# EUROPÄISCHE PATENTANMELDUNG

(11) **EP 2 293 662 A1**
(43) Veröffentlichungstag der Anmeldung: **09.03.2011**
(21) Anmeldenummer: 09011417.4
(22) Anmeldetag: 05.09.2009
(51) Int. Cl.: H05K 13/04, H05K 13/02

(54) **Magazin für elektronische Bauteile**

(71) Anmelder: Sorzio, Armando, 79650 Schopfheim (DE)
(72) Erfinder: Sorzio, Armando, 79650 Schopfheim (DE)
(74) Vertreter: Hahn, Christian

(57) **Zusammenfassung**

Ein Magazin zum Transportieren, Führen und Bereitstellen von Bauteilen an einer Bauteilbestückungsmaschine, umfasst mindestens ein erstes Hohlelement 2, wobei das erste Hohlelement 2 eine Bauteilkammer 5 enthält, welche in einen ersten Endabschnitt mit einer Ausgabeöffnung umfasst, wobei die Bauteilkammer 5 mit Bauteilen in Form eines verschiebbaren Stapels befüllbar ist, wobei die Bauteilkammer 5 in einem der Ausgabeöffnung abgewandten zweiten Endabschnitt eine Eintrittsöffnung für ein Druckgas aufweist, über welche das der Austrittsöffnung abgewandte Ende des Stapels oder ein zwischen dem Ende des Stapels und der Eintrittsöffnung angeordneter Kolben 4 mit einem Druckgas beaufschlagbar ist, um den Stapel in Richtung der Ausgabeöffnung zu verschieben, wobei das Magazin ein zweites Hohlelement 1 mit einem Druckgaseintrittsöffnung und einer Druckgasaustrittsöffnung umfasst, wobei das zweite Hohlelement mit dem ersten Hohlelement verbunden ist, wobei die Eintrittsöffnung der Bauteilkammer über das Druckgasaustrittsöffnung des zweiten Hohlelements mit dem Druckgas beaufschlagbar ist.

## Beschreibung

Die vorliegende Erfindung betrifft ein Magazin für elektronische Bauteile, beispielsweise SMD-Bauteile. Derartige Magazine werden insbesondere in Bestückungsautomaten für die Bestückung von Leiterplatten eingesetzt.

Ein derartiges Magazin dient zum Transportieren, Führen und Bereitstellen von elektrischen Bauelementen, insbesondere SMD Bauteilen an einer Bauteilbestückungsmaschine, wobei das Magazin ein Hohlelement mit einer Ausgabeöffnung umfasst, in welchem die Bauteile als verschiebbarer Stapel enthalten sind, wobei das Hohlelement an einem der Ausgabeöffnung abgewandten Endabschnitt eine Druckgaseintrittsöffnung aufweist, über welche der Stapel mit einem Druckgas beaufschlagbar ist, um den Stapel in Richtung der Ausgabeöffnung zu verschieben.

Ein derartiges Magazin kann zugleich als Verpackung für Bauteile dienen, wobei die Bauteile im Magazin gepackt geliefert werden können.

Bei der Bestückung von Leiterplatten werden elektronische SMD Bauteile (surface mounted devices) einer Bauteilbestückungsmaschine zum mechanischen und/oder elektronischen Montieren der Bauteile auf einer Leiterplatte zugeführt.

Die Bereitstellung der SMD Bauteile erfolgt als Schüttgut, im Magazin in der Form von Schienen oder Trays bzw. Paletten mit Fächern oder im Gurt, je nach Bauteiltyp, Arbeitsweise oder Art der Bestückungsköpfe der eingesetzten Bauteilbestückungsmaschine.

Als Verpackung und Lieferform von SMD-Bauteilen hat sich die Gurtform mehr verbreitet und durchgesetzt. Circa 90% der SMD Bauteile werden gegurtet geliefert.

Die Bereltstellung von Bauteilen in Gurten ist jedoch sehr aufwendig und erfordert insbesondere eine individuelle Abstimmung des Gurtvortriebs auf die Bauteilgröße. ICs und andere große Bauteile werden auch in Kunststoffstangen oder in kleinen Paletten, so genannten Trays, verpackt. Während die Trays direkt in die Maschine oder in eine dafür vorgesehene Einheit eingelegt werden können, sind für die Stangen spezielle Fördereinrichtungen erforderlich. Daher besteht ein Interesse an einfach zu bedienenden Magazinen.

Aus der DE 2716330 A1 ist ein Magazin bekannt, in dem Bauelemente in Chipbauform in gestapelten Zustand von einem Stopfenglied in einem Rohr mit rechteckigem Querschnitt abgestützt sind. Das Magazin hat einen Innenraum der im Querschnitt der Grundfläche der Bauelemente entspricht. Die Bereltstellung des Bauelementes erfolgt durch einen Schubstift, der den Stapel nach oben schiebt.

Ein ähnliches Magazin ist aus der DE 3039782 A1 bekannt.

Aus der DE 3125097 Ist ein Magazin für elektrische Bauelemente bekannt, bestehend aus einem Rohr, insbesondere einem Rohr mit Rechteck Querschnitt zur Aufnahme eines Stapels von elektrischen Bauelementen in dessen Innenraum und mit einem durch das Rohr bewegbar angeordneten Stopfglied, das die gestapelten Bauelemente trägt.

Aus der DE 3115831 A1 ist eine Vorrichtung mit rohrförmigen Magazinen, in welchen Bauelemente als verschiebbarer Stapel enthalten sind und direkt oder durch einen als Kolben wirkenden Teil mit Druckgas beaufschlagt werden, so dass jeweils ein Bauelement aus den Magazin heraus gedrückt wird.

Magazine oder Vorrichtungen bei denen die Bauteile stapelförmig enthalten sind, sind auch aus dem DE 92 11 355 U1, DE 9208743 U1 und DE 29708150 U1 bekannt.

Es ist in der älteren Patentanmeldung DE 3040357 A1 bereits vorgeschlagen worden, die Fortbewegung der Bauelementstapel in den Magazinen von Bestückungsvorrichtungen mittels pneumatisch wirkender Vorrichtungen vorzunehmen. Die vorgeschlagene Vorrichtung weist gesondert einen pneumatischen Druckzylinder mit einem darin beweglichen Kolben und Kolbenstangen auf.

Alle die genannten Magazine und Vorrichtungen haben den gemeinsamen Nachteil, dass sie nach dem heutigen Stand der Technik nicht an einem modernen Bestückungsautomaten wirtschaftlich verwendet werden können.

Die Aufgabe der vorliegenden Erfindung besteht darin, ein Magazin anzugeben für die vereinfachte Bereitstellung von Bauteilen für die Handhabung und Entnahme an einer Bauteilbestückungsmaschine.

Nach einem weiteren Gesichtspunkt der Erfindung soll ein einheitliches Magazin und Bereitstellungssystem für alle auf dem Markt erhältlichen Bauteile geschaffen werden, die heute je nach Typ oder Bauform, in Gurten, auf Trays, oder in Stangen gellefert und mit unterschiedlichen Systemen zur Bestückung bereitgestellt werden.

Nach einem weiteren Gesichtspunkt der Erfindung sollen die Magazine zur Bereitstellung der Bauelemente wieder verwendet werden können.

Die Aufgabe wird erfindungsgemäß durch das Magazin gemäß dem unabhängigen Patentanspruch 1

Das erfindungsgemäße Magazin zum Transportieren, Führen und Bereitstellen von Bauteilen an einer Bauteilbestückungsmaschine umfasst mindestens ein erstes Hohlelement,

wobei das erste Hohlelement eine Bauteilkammer enthält, welche in einen ersten Endabschnitt mit einer Ausgabeöffnung umfasst,

wobei die Bauteilkammer mit Bauteilen in Form eines verschiebbaren Stapels befüllbar ist,

wobei die Bauteilkammer in einem der Ausgabeöffnung abgewandten zweiten Endabschnitt eine Eintrittsöffnung für ein Druckgas aufweist, über welche das der Austrittsöffnung abgewandte Ende des Stapels oder ein zwischen dem Ende des Stapels und der Eintrittsöffnung angeordneter Kolben mit einem Druckgas beaufschlagbar ist, um den Stapel in Richtung der Ausgabeöffnung zu verschieben,

**dadurch gekennzeichnet, dass** das Magazin ein zweites Hohlelement mit einem Druckgaseintrittsöffnung und einer Druckgasaustrittsöffnung umfasst,

wobei das zweite Hohlelement mit dem ersten Hohlelement verbunden ist,

wobei die Eintrittsöffnung der Bauteilkammer über die Druckgasaustrittsöffnung des zweiten Hohlelements mit dem Druckgas beaufschlagbar ist.

Nach einer Ausgestaltung der Erfindung weist das erste Hohlelement eine Längsachse auf, die sich im wesentlichen parallel zur Förderrichtung eines Bauteilstapels in der Bauteilkammer erstreckt, wobei die Erstreckung des ersten Hohlelements in Richtung der Längsachse des ersten Hohlelements mehr als 10-Fache einer Erstreckung des ersten Hohlelements in einer beliebigen Richtung senkrecht zur Längsachse beträgt.

Nach einer Ausgestaltung der Erfindung ist die Druckgaseintrittsöffnung des zweiten Hohlelements in einem der Drurkgasaustrittsöffnung abgewandten Endabschnitt des zweiten Hohlelementes angeordnet.

In einer Weiterbildung dieser Ausgestaltung der Erfindung ist die Druckgaseintrittsöffnung in Richtung der Längsachse des ersten Hohlelements nicht mehr als 20% vorzugsweise nicht mehr als 10%, weiter bevorzugt nicht mehr als 5% der Längserstreckung des ersten Hohlelements von der Ausgabeöffnung beabstandet.

In einer Ausgestaltung der Erfindung sind das erste und das zweite Hohlelement koaxial zueinander angeordnet, wobei das zweite Hohlelement das erste Hohlelement koaxial umgibt.

In diesem Fall kann die Druckgasaustrittsöffnung eine Öffnung in einer Trennwand zwischen dem inneren ersten Hohlelement und dem äußeren zweiten Hohlelement umfassen.

Abgesehen von der Druckgasaustrittsöffnung und der Druckgaseintrittsöffnung ist das zweite Hohlelement vorzugsweise luftdicht geschlossen.

In einer Weiterbildung der Erfindung umfasst das äußere Höhlelement eine Ringkammer um das innere Hohlelement.

In einer Weiterbildung der Erfindung umfasst das Magazin einen in der Bauteilkammer angeordneten Kolben, weicher einerseits unter dem Eigengewicht eines Bauteilstapels nicht rutscht, und andererseits beim Anlegen eines Druckes den Bauteilstapel in Förderrichtung verschiebt.

Hierzu kann der Kolben beispielsweise senkrecht zur Förderrichtung gegen die Wand der Bauteilkammer elastisch vorgespannt sein.

Die Bauteilkammer kann weiterhin einen Querschnitt aufweisen, weicher der Grundfläche der Bauteile entspricht.

Die Bauteilkammer kann gemäß einer Ausgestaltung der Erfindung einen Querschnitt aufweisen, der dazu dient, die Bauteile besser zu führen oder deren Rotation zu verhindern.

Nach einer Weiterbildung der Erfindung können das erste und das zweite Hohlelement im wesentlichen als ein Teil gebildet sein.

In einer Weiterbildung der Erfindung umfasst das Magazin an der Ausgabeöffnung einen Anschlag, der dazu Vorgesehen ist den Vorschub des Bauteilstapels zu begrenzen, wobei das jeweils oberste abzuholenden Bauteil durch den Anschlag in einer definierten Abholhöhe gestoppt wird.

In einer Weiterbildung umfasst das Magazin an einem Endabschnitt, der die Druckgaseintrittöffnung enthält, Konturelemente wie Vorsprünge oder Aussparungen, mit denen die Position des Magazins in einer Fördereinrichtung vorzugsweise formschlüssig festgelegt werden kann.

In einer Weiterbildung der Erfindung umfasst der ausgabeöffnungsseitige Endabschnitt des ersten Hohlelementes einen flexiblen und federnden Werkstoff.

Unter Anlegen eines Druckes in einer Ringkammer um das erste Hohlelement kann damit beispielsweise der Endabschnitt nach innen gedrückt werden, um die Bauteile - außer dem abzuholenden Bauteil - festzuhalten.

Das zweite Hohlelement kann auch neben dem ersten Hohlelement angeordnet sein, so dass die beiden Hohlelemente beispielsweise wie zwei parallele Rohre verlaufen, die an einem Ende miteinander kommunizieren, um eine Verbindung zwischen der Druckgasaustrittsöffnung des zweiten Hohlelements mit der Eintrittsöffnung des ersten Hohlelements zu ermöglichen.

Sämtliche zuvor beschriebenen Ausgestaltungsmerkmale, die nicht ausdrücklich auf die koaxiale Anordnung der Hohlelemente beschränkt sind, können auch mit der Variante der nebeneinander angeordneten Hohlelemente verwirklicht werden.

Weitere Einzelheiten der Erfindung werden nun anhand der in den Zeichnungen dargestellten Ausführungsbeispiele erläutert.

Es zeigt:

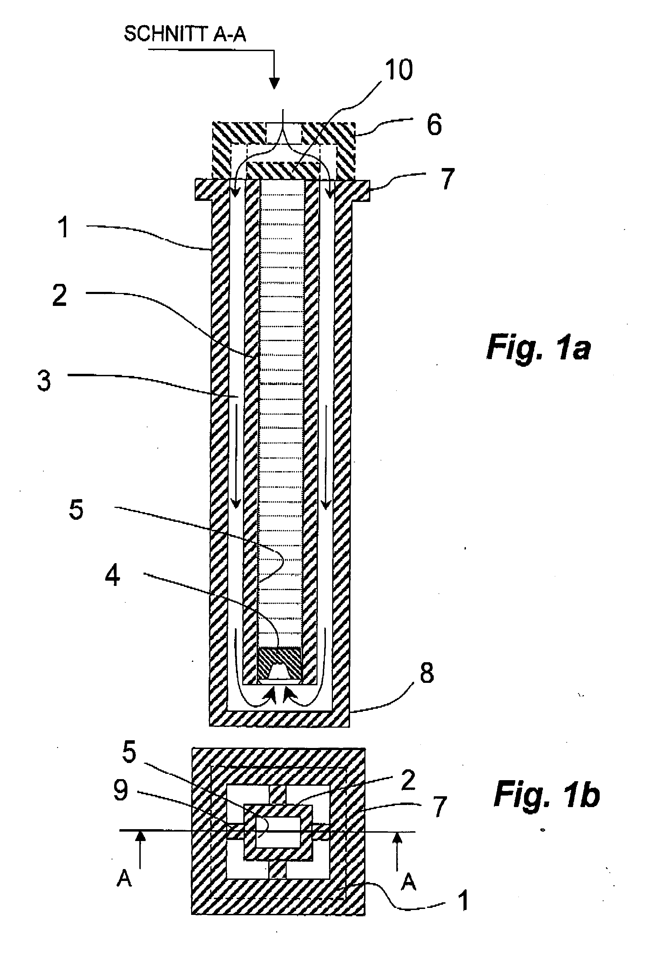

- Fig. 1a:: einen Längsschnitt durch ein erstes Ausführungsbeispiel eines erfindungsgemäßen Magazins;
- Fig. 1 b:: eine Aufsicht auf ein erstes Ausführungsbeispiel eines erfindungsgemäßen Magazins;
- Fig. 2a:: einen Längsschnitt durch ein zweites Ausführungsbeispiel eines erfindungsgemäßen Magazins;
- Fig. 2b:: eine Aufsicht auf ein zweites Ausführungsbeispiel eines erfindungsgemäßen Magazins;

Das in Fign. 1 a und b dargestellte Magazin umfasst ein erstes, inneres Hohlelement 2 und ein zweites, äußeres Hohlelement 1, welche das innere Hohlelement 2 umgibt.
Das äußere Hohlelement 1 ist an einem unteren Ende 8 luftdicht geschlossen. Das innere Hohlelement 2 ist schmaler und kürzer als das äußere Hohlelement 1, so dass zwischen den der Wand des inneren Hohlelements 1 und der Wand des äußeren Hohlelements 1 ein Hohlraum 3 gebildet ist, und dass an dem geschlossenen Ende 8, der Hohlraum 3 mit einer Bauteilkammer 5 im innern des inneren Hohlelements 1 kommuniziert.

In einem Unteren abschnitt der Bauteilkammer 5 ist ein Kolben 4 angeordnet, wobei der Kolben radial gegen die Wand der Bauteilkammer 5 vorgespannt ist, um unter Druckbeaufschlagung in der Bauteilkammer befindliche Bauteile nach oben zu fördern.
Auf diesem Kolben 4 liegen die Bauteile, aufeinander gestapelt.

Der Vorschubdruck für den Vorschub des Kolbens bzw. der Bauteile wird an das äußere Hohlelement 1 angelegt und gelangt über den Hohlraum 3 an die Unterseite der Bauteilkammer 5.

Der Vorschubdruck kann beispielsweise mittels eines klappbaren oder verschiebbaren Glieds 6 angelegt werden, oder mittels einer Feeder-änlichen Einrichtung, die mit dem Magazin ausgerüstet werden kann.
Der Vorschubdruck wird in dem Holraum3 zwischen den zwei Hohlelementen, während eine Ausgabeöffnung des inneren Hohlelements 2, in dem die Bauteile sich aufeinander gestapelt befinden, durch einen Vorsprung 10 im Glied 6 oder einen Anschlag, geschlossen gehalten wird. Dieser Anschlag bzw. Vorsprung 10 dient auch dazu, zu verhindern, dass die Bauteile aus dem Magazin herausspringen und um zu gewährieisten, dass eine identische Abholhöhe für jedes Bauteil festgelegt ist.

Unmittelbar nach dem erfolgten Vorschub wird zumindest die Ausgabeöffnung des inneren Hohlelements 2 wieder frei gemacht, so dass das obere Bauteil vom Bestückkopf abgeholt werden kann.

Die Feeder - und Vorschubeinrichtung könnte auch für die Aufnahme von mehreren Magazinen ausgelegt werden. Nach der Entleerung eines Magazins dies wirdwird dies automatisch entfernt und das nächste Bauteil wird zur Vorschubsposrtion geführt oder getaktet.

Die Positionierung in den Raumrichtungen x, y und z erfolgt somit nicht durch Parameter die für die verschiedenen Bauformen hinterlegt sind, sondern sie ergibt sich durch einen einfachen Anschlag. Die gleiche Entnahmeposition kann damit für alle Bauteile unterschiedlicher Dimensionen mechanisch bestimmt werden.
Der Software-Aufwand wird damit vereinfacht.

Da die Bauteile aufeinanderliegend zur Entnahme getaktet werden, ist für die Positionierung in x und in y keine vom Bauteilabmessungen abhängige spezifische Steuerung notwendig. Die gleiche, wiederholgenaue Entnahmeposition des Bauteils ist für die parallele Entnahme, also die gleichzeitige Entnahme durch einen Bestückkopf mit mehrfacher Bestücknadel Ausstattung, grundlegend.

Um das Magazin in eine Druckanlegevorrichtung bzw. Vorschubeinrichtung aufzurüsten und um zu verhindern dass das Magazin durch das Glied 6 oder durch den Druckimpuls weggedrückt wird, kann das Magazin, an dem Ende auf dem der Druck angelegt wird oder entlang des Elementes, ein Konturelement wie den Vorsprung 7 oder Rastmittel aufweisen, um die Position des Magazins festzuhalten.

In einer Weiterbildung der Erfindung kann ein wegklappbares Absperrelement oder eine Verschlusskappe vorgesehen werden, um beim Abrüsten und Transportieren der Magazine, das Herausfallen der Bauteile verhindern kann.

Ein signifikanter Vorteil der vorliegenden Erfindung besteht darin, dass die eingesetzten Materialien wieder verwendet werden können. Nach dem Entleeren können die Magazine an den Hersteller zurückgeliefert und neu befüllt werden.

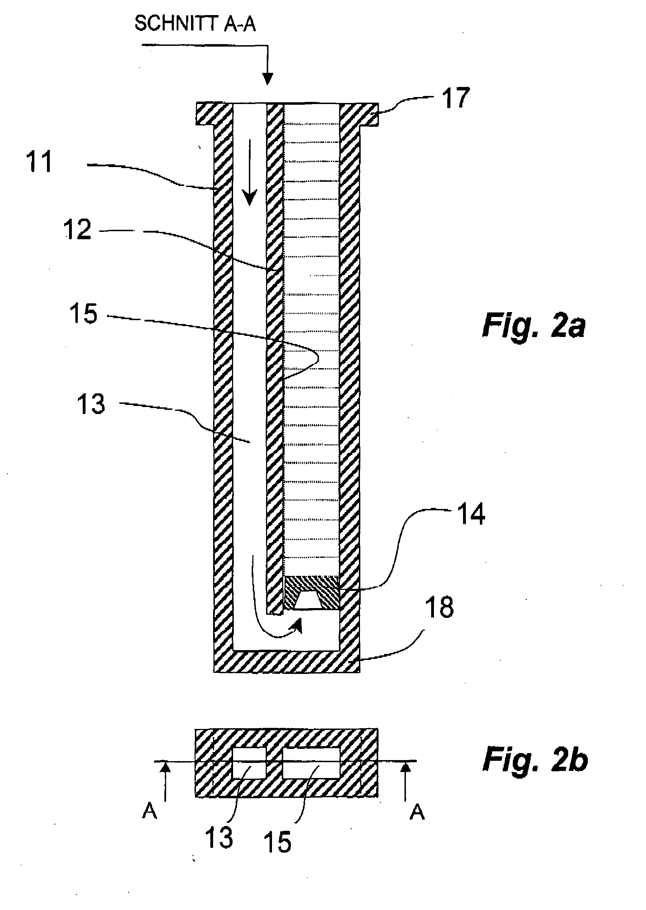

Das in Fign. 2a und b dargestellte Magazin umfasst zwei nebeneinander angeordnete Hohlelemente 11 und 12, wobei das erste Hohlelement 12 eine Bauteilkammer 15 enthält, die einen Stapel von Bauteilen aufnehmen kann, und wobei die Bauteilkammer 15 über einen Hohlraum 13 des zweiten Hohlelements 11 mit einem Vorschubdruck beaufschlagbar ist, da der Hohlraum 13 in einem unteren Endabschnitt 18 des Magazins mit der Bauteilkammer 15 über eine Offnung kommuniziert, die als Druckgasaustrittsöffnung des zweiten Hohlelements 11, bzw. als Eintrittsöffnung des ersten Hohlelements 12 dient. In der Bauteilkammer 15 ist wieder ein Kolben 14 in der Weise angeordnet, wie es im Zusammenhang mit dem ersten Ausführungsbeispiel beschrieben wurde. Ein seitlicher Vorsprung 17 ist am oberen Rand des Magazins vorgesehen, um die Lage des Magazins in einer Feeder- bzw. Vorschubvorrichtung zu fixieren. Die Druckbeaufschlagung erfolgt wie beim ersten Ausführungsbeispiel über ein Glied, welches auf das Magazin aufsetzt.

Weitere Abwandlungen ergeben sich für den Fachmann ohne vom Geist der Erfindung abzuweichen, die in den Ansprüchen definiert ist.

Beispielsweise kann das zweite Hohlelement einen Schlauch umfassen, der sich von einer Druckgaseintrittsöffnung in der Nähe der Ausgabeöffnung des ersten Hohlelements zu einer Eintrittsöffnung in einem unteren Endabschnitt des ersten Hohlelements erstreckt.

## Patentansprüche

1. Magazin zum Transportieren, Führen und Bereitstellen von Bauteilen an einer Bauteilbestückungsmaschine, umfassend:
mindestens ein erstes Hohlelement (2),
wobei das erste Hohlelement (2) eine Bauteilkammer (5) enthält, welche in einen ersten Endabschnitt mit einer Ausgabeöffnung umfasst,
wobei die Bauteilkammer (5) mit Bauteilen in Form eines verschiebbaren Stapels befüllbar ist,
wobei die Bauteilkammer (5) in einem der Ausgabeöffnung abgewandten zweiten Endabschnitt eine Eintrittsöffnung für ein Druckgas aufweist, über welche das der Austrittsöffnung abgewandte Ende des Stapels oder ein zwischen dem Ende des Stapels und der Eintrittsöffnung angeordneter Kolben (4) mit einem Druckgas beaufschlagbar ist, um den Stapel in Richtung der Ausgabeöffnung zu verschieben,
wobei das Magazin ein zweites Hohlelement (1) mit einem Druckgaseintrittsöffnung und einer Druckgasaustrittsöffnung umfasst,
wobei das zweite Hohlelement mit dem ersten Hohlelement verbunden ist,
wobei die Eintrittsöffnung der Bauteilkammer über das Druckgasaustrittsöffnung des zweiten Hohlelements mit dem Druckgas beaufschlagbar ist, und
wobei die Druckgaseintrittsöffnung des zweiten Hohlelements neben der Ausgabeöffnung der Bauteilekammer angeordnet ist.

2. Magazin nach Anspruch 1, wobei das erste Hohlelement eine Längsachse aufweist, die sich im wesentlichen parallel zur Förderrichtung eines Bauteilstapels in der Bauteilkammer erstreckt, wobei die Erstreckung des ersten Hohlelements in Richtung der Längsachse des ersten Hohlelements mehr als das 10-fache einer Erstreckung des ersten Hohlelements in einer beliebigen Richtung senkrecht zur Längsachse beträgt.

3. Magazin nach Anspruch 1 oder 2, wobei die Druckgaseintrittsöffnung des zweiten Hohlelements in einem der Druckgasaustrittsöffnung abgewandten Endabschnitt des zweiten Hohlelementes angeordnet ist.

4. Magazin nach Anspruch 3, wobei die Druckgaseintrittsöffnung in Richtung der Längsachse des ersten Hohlelements nicht mehr als 20% vorzugsweise nicht mehr als 10%, weiter bevorzugt nicht mehr als 5% der Längserstreckung des ersten Hohlelements von der Ausgabeöffnung beabstandet ist.

5. Magazin nach einem der vorhergehenden Ansprüche wobei das erste und das zweite Hohlelement im wesentlichen koaxial zueinander angeordnet sind, wobei das zweite Hohlelement das erste Hohlelement umgibt.

6. Magazin nach Anspruch 5, wobei die Druckgasaustrittsöffnung eine Öffnung in einer Trennwand zwischen dem inneren ersten Hohlelement und dem äußeren zweiten Hohlelement umfasst.

7. Magazin nach einem der Ansprüche 5 oder 6, wobei das äußere Hohlelement eine Ringkammer um das innere Hohlelement umfasst.

8. Magazin nach einem der vorhergehenden Ansprüche, weiterhin umfassend, einen in der Bauteilkammer angeordneten Kolben, welcher einerseits unter dem Eigengewicht eines Bauteilstapels nicht rutscht, und andererseits beim Anlegen eines Drucks den Bauteilstapel in Förderrichtung verschiebt.

9. Magazin nach Anspruch 8, wobei der Kolben senkrecht zur Förderrichtung gegen die Wand der Bauteilkammer elastisch vorgespannt ist.

10. Magazin nach einem der vorhergehenden Ansprüche, wobei der Querschnitt der Bauteilkammer, der Grundfläche der Bauteile (5) entspricht.

11. Magazin nach einem der vorhergehenden Ansprüche, wobei die Bauteilkammer einen Querschnitt aufweist, der dazu dient die Bauteile zu führen oder eine Rotation zu verhindern.

12. Magazin nach einem der vorhergehenden Ansprüche, wobei das erste und das zweite Hohlelement im wesentlichen als ein Teil gebildet sind.

13. Magazin nach einem der vorhergehenden Ansprüche, wobei das Magazin an der Ausgabeöffnung einen Anschlag aufweist, oder auf das Magazin ein solcher Anechlag aufsetzbar ist, der dazu vorgesehen ist, den Vorschub des Bauteilstapels zu begrenzen, wobei jeweils ein oberstes abzuholendes Bauteil durch den Anschlag in einer definierten Abholhöhe gestoppt wird.

14. Magazin nach einem der vorhergehenden Ansprüche, wobei das Magazin an einem Endabschnitt, der die Druckgaselntrlttoffnung enthalt, Konturelemente aufweist, mit denen die Position des Magazins in einer Fördereinrichtung vorzugsweise formschlüssig festgelegt werden kann.

15. Magazin nach einem der Ansprüche 1 bis 4, wobei das erste Hohlelement neben dem zweiten Hohlelement angeordnet ist.
